# EUROPEAN PATENT APPLICATION

(11) **EP 2 543 753 A1**
(43) Date of publication of application: **09.01.2013**
(21) Application number: 11750469.6
(22) Date of filing: 16.02.2011
(51) Int. Cl.: C30B 29/36, C30B 23/06

(54) **METHOD FOR PRODUCING SILICON CARBIDE CRYSTAL, SILICON CARBIDE CRYSTAL, AND DEVICE FOR PRODUCING SILICON CARBIDE CRYSTAL**

(30) Priority: 02.03.2010 JP 2010045372
(71) Applicant: Sumitomo Electric Industries, Ltd., Chuo-ku Osaka-shi Osaka 541-0041 (JP)
(72) Inventor: NISHIGUCHI, Taro, Itami-shi Hyogo 664-0016 (JP)
(74) Representative: Grünecker, Kinkeldey, Stockmair & Schwanhäusser
(86) International application number: PCT/JP2011/053273
(87) International publication number: WO 2011/108356

(57) **Abstract**

A production method of a SiC crystal (10) includes the following steps. That is, there is prepared a production device (100) including a crucible (101) and a heat insulator (121) covering an outer circumference of the crucible (101). A source material (17) is placed in the crucible (101). A seed crystal (11) is placed opposite to the source material (17) in the crucible (101). The silicon carbide crystal (10) is grown by heating the source material (17) in the crucible (101) for sublimation thereof and depositing resultant source material gas on the seed crystal (11). The step of preparing the production device (100) includes the step of providing a heat dissipation portion (131, 132), which is constituted by a space, between the heat insulator (121) and an outer surface (101 a) of the crucible (101) at a side of the seed crystal (11).

## Description

### TECHNICAL FIELD

The present invention relates to a production method of a silicon carbide (SiC) crystal, the SiC crystal, and a production device of the SiC crystal.

### BACKGROUND ART

SiC crystals have a large band gap, and has a maximum dielectric breakdown electric field and a heat conductivity both larger than those of silicon (Si). In addition, such SiC crystals have a carrier mobility as large as that of Si, and have a large electron saturation drift velocity and a large breakdown voltage. Hence, it is expected to apply the SiC crystals to semiconductor devices, which are required to attain high efficiency, high breakdown voltage, and large capacity.

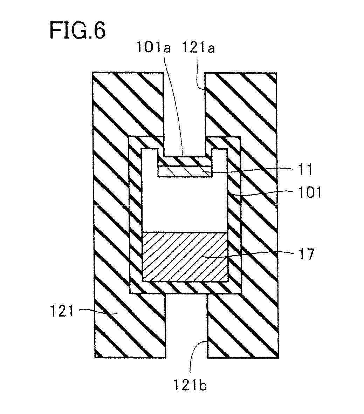

A SiC crystal used for such semiconductor devices or the like is produced using, for example, a sublimation method in vapor phase epitaxy (for example, Non-Patent Literature 1 (G. AUGUSTINE et al., "Physical Vapor Transport Growth and Properties of SiC Monocrystals", Phys.stat.sol. (b) vol.202 (1997), p.137-139)). Fig. 6 is a cross sectional view schematically showing a production device of SiC in the disclosure of Non-Patent Literature 1. Referring to Fig. 6, the following describes the production device of a SiC crystal and a growth method therefor in the disclosure of Non-Patent Literature 1.

As shown in Fig. 6, the production device of SiC in the disclosure of Non-Patent Literature 1 includes a crucible 101, and a heat insulator 121 covering the outer circumference of crucible 101. At a lower portion of crucible 101, a source material 17 for the SiC crystal is placed. At an upper portion of crucible 101, a seed crystal 11 is placed opposite to source material 17. Heat insulator 121 has an opening 121 a and an opening 121b. Opening 121 a is formed at a side of seed crystal 11 placed in crucible 101, so as to extend through the outer circumference of heat insulator 121. Opening 121b is formed at a side of source material 17 placed in crucible 101, so as to extend through the outer circumference of heat insulator 121.

In this state, source material 17 is heated to a temperature at which source material 17 is sublimated. By this heating, source material 17 is sublimated to generate sublimation gas, thereby growing a SiC crystal on a surface of seed crystal 11, which is set to have a lower temperature than that of source material 17.

### CITATION LIST

### NON PATENT LITERATURE

NPL 1: G. AUGUSTINE et al., "Physical Vapor Transport Growth and Properties of SiC Monocrystals", Phys.stat.sol. (b) vol.202 (1997), p.137-139

### SUMMARY OF INVENTION

### TECHNICAL PROBLEM

In the case where heat insulator 121 has opening 121 a at the seed crystal 11 side as in Non-Patent Literature 1, the temperature of opening 121 a is low because heat can be dissipated upon start of the growth of SiC crystal. However, when source material gas leaks out of crucible 101 and is then attached in opening 121a, a SiC crystal is attached therein because opening 121 a has the low temperature. Accordingly, opening 121 a may be filled therewith. If opening 121 a provided in heat insulator 121 is filled during the growth, growth condition is changed. This leads to deteriorated crystallinity of the SiC crystal to be grown.

In view of the above, the present invention relates to a production method of a SiC crystal, the SiC crystal, and a production device of the SiC crystal, each of which achieves good crystallinity of the SiC crystal.

### SOLUTION TO PROBLEM

A production method of a SiC crystal according to the present invention includes the following steps. That is, there is prepared a production device including a crucible and a heat insulator covering an outer circumference of the crucible. A source material is placed in the crucible. A seed crystal is placed opposite to the source material in the crucible. The silicon carbide (SiC) crystal is grown by heating the source material in the crucible for sublimation thereof and depositing resultant source material gas on the seed crystal. The step of preparing the production device includes the step of providing a heat dissipation portion, which is constituted by a space, between the heat insulator and an outer surface of the crucible at a side of the seed crystal.

A production device of a SiC crystal in the present invention is a device for growing the SiC crystal by sublimating a source material containing SiC, and depositing source material gas, which results from the sublimation, on a seed crystal. The production device includes a crucible, a heat insulator, a heat dissipation portion, and a heating unit. The crucible contains the source material and the seed crystal therein. The heat insulator covers an outer circumference of the crucible. The heat dissipation portion is constituted by a space and is provided between the heat insulator and an outer surface of the crucible at a side of the seed crystal. The heating unit heats inside of the crucible.

According to the production device and method of the SiC crystal in the present invention, the heat insulator covers the heat dissipation portion provided at the outer surface of the crucible at the seed crystal side. Accordingly, gas leaking from the crucible can be prevented from entering the heat dissipation portion. Hence, the heat dissipation portion can be prevented from being filled therewith during the growth of SiC crystal. Because the heat dissipation portion can be maintained as a space at the growth temperature of SiC crystal, heat at the seed crystal side of the crucible can be dissipated to outside the production device by heat conduction resulting from radiation. Accordingly, during the growth of SiC crystal, the temperature of the seed crystal can be prevented from being changed. Accordingly, growth condition can be prevented from being changed during the growth of SiC crystal, thereby achieving good crystallinity of the SiC crystal.

Preferably in the production method of the SiC crystal, in the step of preparing the production device, the heat insulator prepared contains carbon (C) as its main component. Preferably in the production device of the SiC crystal, the heat insulator contains C as its main component.

Accordingly, the heat insulator made of a material stable in the atmosphere for growing the SiC crystal can be used, thus suppressing a change in growth condition during the growth of SiC crystal. Accordingly, the SiC crystal produced can be provided with good crystallinity.

Preferably in the production method of the SiC crystal, in the production device prepared in the step of preparing the production device, the heat insulator covering the outer circumference of the crucible is formed of a plurality of heat insulating sheets stacked on one another.

Preferably in the production device of the SiC crystal, the heat insulator is formed of a plurality of heat insulating sheets stacked on one another.

The heat dissipation portion can be readily formed by providing an opening in at least one of the plurality of heat insulating sheets, and covering the opening with another heat insulating sheet.

Preferably in the production method of the SiC crystal, in the step of growing the silicon carbide crystal, the source material is heated using a high-frequency heating method or a resistive heating method.

Preferably in the production device of the SiC crystal, the heating unit is a high-frequency heating coil or a resistive heating heater.

Because the high-frequency heating coil and the resistive heating heater can be readily controlled in terms of temperature, a change in temperature can be suppressed during the growth of SiC crystal. Accordingly, the SiC crystal can be provided with good crystallinity.

Preferably in the production method of the SiC crystal, in the step of preparing the production device, the crucible prepared contains C as its main component. Preferably in the production method of the SiC crystal, the crucible contains C as its main component.

Accordingly, the crucible made of a material stable in the atmosphere for growing the SiC crystal can be used, thus suppressing a change in growth condition during the growth of SiC crystal. Accordingly, the SiC crystal produced can be provided with good crystallinity.

A SiC crystal of the present invention is produced using any of the above-described production methods of the SiC crystal. The SiC crystal of the present invention is produced with the growth condition being prevented from changing during the growth of SiC crystal, thereby achieving good crystallinity of the SiC crystal.

Preferably, the SiC crystal has a crystalline polymorphism (polytype) of 4H-SiC. Accordingly, a material for a device with high breakdown voltage can be attained.

### ADVANTAGEOUS EFFECTS OF INVENTION

According to the production method of the SiC crystal, the SiC crystal, and the production device of the SiC crystal in the present invention, the heat dissipation portion prevents a change in growth condition during the growth of SiC crystal, thereby achieving good crystallinity in the SiC crystal.

### BRIEF DESCRIPTION OF DRAWINGS

Fig. 1 is a cross sectional view schematically showing a SiC crystal in an embodiment of the present invention.
Fig. 2 is a cross sectional view schematically showing a production device of a SiC crystal in the embodiment of the present invention.
Fig. 3 is a cross sectional view schematically showing a vicinity of a crucible of a production device of a SiC crystal in a first variation of the embodiment of the present invention.
Fig. 4 is a cross sectional view schematically showing a vicinity of a crucible of a production device of a SiC crystal in a second variation of the embodiment of the present invention.
Fig. 5 is a cross sectional view schematically showing a vicinity of a crucible of a production device of a SiC crystal in a comparative example.
Fig. 6 is a cross sectional view schematically showing a vicinity of a crucible of a production device of a SiC crystal in Non-Patent Literature 1.

### DESCRIPTION OF EMBODIMENTS

The following describes an embodiment of the present invention with reference to figures. It should be noted that in the below-mentioned figures, the same or corresponding portions are given the same reference characters and are not described repeatedly.

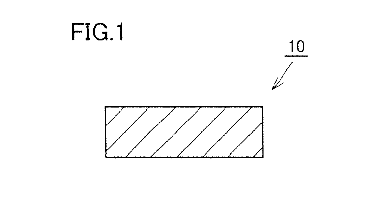

First, referring to Fig. 1, the following describes a SiC crystal 10 in one embodiment of the present invention. SiC crystal 10 has good crystallinity. The polytype of SiC crystal 10 is not particularly limited but is preferably 4H-SiC.

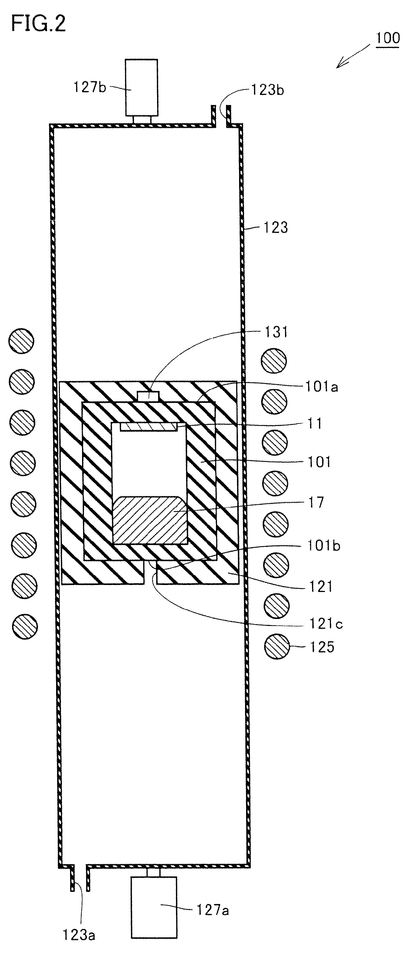

Next, referring to Fig. 2, a production device 100 of such a SiC crystal in the present embodiment will be described. Production device 100 is a device for growing a SiC crystal using the sublimation method. In other words, production device 100 is a device for growing SiC crystal 10 by sublimating a source material 17 containing SiC, and depositing source material gas, which results from the sublimation, on a seed crystal 11.

As shown in Fig. 2, production device 100 mainly includes: a crucible 101, a heat insulator 121, a reaction chamber 123, heating units 125, and a heat dissipation portion 131.

Crucible 101 accommodates seed crystal 11 and source material 17 therein. Crucible 101 preferably contains C as its main component, and more preferably contains C as its main component and an inevitable impurity as its remnants. In this case, crucible 101 is made of a material stable in the growth condition for SiC crystal, thus suppressing a change in growth condition during the growth of SiC crystal. Accordingly, the SiC crystal produced can be provided with good crystallinity. A preferable, exemplary material for crucible 101 is graphite. Graphite is stable at a high temperature, thereby suppressing cracks in crucible 101. Further, C constituting crucible 101 is an element constituting the SiC crystal. Hence, even if crucible 101 is sublimated and a sublimate thereof comes into the SiC crystal, the sublimate does not become an impurity. Accordingly, the SiC crystal produced can have better crystallinity.

Heat insulator 121 covers the outer circumference of crucible 101. Heat insulator 121 preferably contains C as its main component, and more preferably contains C as its main component and an inevitable impurity as its remnants. A preferable, exemplary material for the heat insulator is carbon felt. Such a heat insulator, which provides a heat insulation effect, can suppress a change in growth condition during the growth of SiC crystal. Hence, also in this case, the SiC crystal produced can have good crystallinity. Further, in the present embodiment, a temperature measurement hole 121c is formed at the source material 17 side in heat insulator 121.

Heat dissipation portion 131 is disposed between heat insulator 121 and an outer surface 101a of crucible 101 at the seed crystal 11 side. In other words, heat dissipation portion 131 is formed to face outer surface 101 a of crucible 101 opposite to its inner surface on which seed crystal 11 is placed (outer surface 101 a located on the back of the surface thereof on which seed crystal 11 is placed). More specifically, heat dissipation portion 131 is a space formed between crucible 101 and heat insulator 121, which covers outer surface 101 a of crucible 101 at the seed crystal 11 side.

Heat dissipation portion 131 is constituted by the space. During the growth of SiC crystal, this space is filled with atmospheric gas such as nitrogen (N₂) gas, helium (He) gas, or argon (Ar) gas.

The center of heat dissipation portion 131 preferably corresponds to the center of crucible 101. In this case, variation of heat conduction in the lateral direction in seed crystal 11 can be suppressed.

Heat dissipation portion 131 preferably encompass an entire portion of a region corresponding to seed crystal 11 in outer surface 101 a of crucible 101, when viewed from the source material 17 side. In this case, heat dissipation from heat dissipation portion 131 provides an effect of highly increasing in-plane uniformity of temperature. It should be noted that heat dissipation portion 131 may encompass a part of the region corresponding to seed crystal 11 in outer surface 101 a of crucible 101, when viewed from the source material 17 side and may not encompass the entire portion of the region. Further, seed crystal 11 placed may encompass an entire portion of a region corresponding to heat dissipation portion 131 in outer surface 101 a of crucible 101, when viewed from the source material 17 side.

Heat insulator 121 is surrounded by reaction chamber 123. At the opposite ends of reaction chamber 123, a gas inlet 123a and a gas outlet 123b are formed. Gas inlet 123a is adapted to provide, for example, atmospheric gas into reaction chamber 123. Gas outlet 123b is adapted to exhaust the atmospheric gas to outside reaction chamber 123.

Outside crucible 101 (outside reaction chamber 123 at a central portion thereof in the present embodiment), heating units 125 are provided to heat the inside of crucible 101. Each of heating units 125 is not particularly limited, but is preferably a high-frequency heating coil or a resistive heating heater. When a high-frequency heating coil is used as heating unit 125, the high-frequency heating coil is preferably provided to face the outer circumference of heat insulator 121. On the other hand, when a resistive heating heater is used as heating unit 125, the resistive heating heater is preferably disposed in heat insulator 121 and external to crucible 101.

Reaction chamber 123 has upper and lower portions respectively provided with radiation thermometers 127b, 127a for measuring temperatures of the upper and lower portions of crucible 101. Radiation thermometer 127a measures the temperature via a temperature measurement hole 121c formed at a portion of heat insulator 121 covering outer surface 101 b of crucible 101 at the source material 17 side. Temperature measurement hole 121c may not be formed.

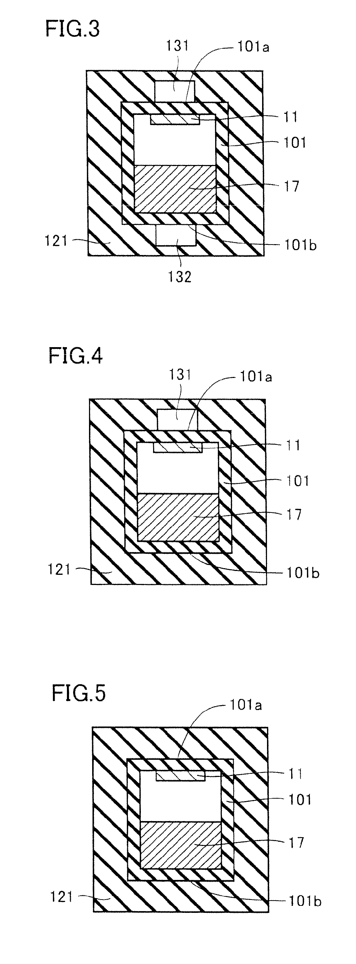

Referring to Fig. 3, a first variation of production device 100 of a SiC crystal in the present embodiment will be described. The production device of the first variation in Fig. 3 has basically the same configuration as that of production device 100 shown in Fig. 2, but is different therefrom in that a heat dissipation portion 132 constituted by a space is further formed between heat insulator 121 and outer surface 101 b of crucible 101 at the source material 17 side, and that temperature measurement hole 121c is not formed in heat insulator 121.

Referring to Fig. 4, a second variation of production device 100 of a SiC crystal in the present embodiment will be described. The production device of the second variation in Fig. 4 has basically the same configuration as that of production device 100 shown in Fig. 2, but is different therefrom in that temperature measurement hole 121c is not formed in heat insulator 121.

It should be noted that production device 100 may include various elements other than those described above, but for ease of description, these elements are not described and not shown in figures.

Referring to Fig. 1-Fig. 4, the following describes a production method of the SiC crystal in each of the present embodiment and the first and second variations.

First, as shown in Fig. 2-Fig. 4, production device 100 is prepared which includes crucible 101 and heat insulator 121 covering the outer circumference of crucible 101. In this step, heat dissipation portion 131 constituted by a space is provided between heat insulator 121 and outer surface 101a of crucible 101 at the seed crystal 11 side. In this step, production device 100 shown in each of Fig. 2-Fig. 4 mentioned above is prepared.

Specifically, it is preferable to prepare heat insulator 121 containing C as its main component. It is preferable to prepare crucible 101 containing C as its main component. It is preferable to dispose heating units 125, each of which is a high-frequency heating coil or a resistive heating heater.

Also, it is preferable to prepare production device 100 in which the outer circumference of crucible 101 is covered with heat insulator 121 obtained by stacking a plurality of heat insulating sheets. In this case, at least one of the plurality of heat insulating sheets is provided with a hole, the heat insulating sheet thus having the hole formed therein is disposed in contact with crucible 101, and remaining heat insulating sheets are disposed to cover the hole. In this way, the hole of the heat insulating sheet serves as heat dissipation portion 131.

Then, as shown in Fig. 2-Fig. 4, source material 17 is placed in crucible 101. Source material 17 may be powder or a sintered compact. For example, polycrystal SiC powder or SiC sintered compact is prepared. In the present embodiment, source material 17 is placed at the lower portion of crucible 101.

Next, as shown in Fig. 2-Fig. 4, seed crystal 11 is placed opposite to source material 17 in crucible 101. In the present embodiment, seed crystal 11 is placed at the upper portion of crucible 101 so as to be opposite to source material 17. The crystal structure of seed crystal 11 is not particularly limited, and may be the same crystal structure as that of the SiC crystal to be grown or may be a crystal structure different therefrom. In order to improve the crystallinity of the SiC crystal to be grown, a SiC crystal having the same crystal structure as the SiC crystal to be grown is preferably prepared as seed crystal 11.

Next, in crucible 101, the SiC crystal is grown by sublimating source material 17 by means of heating and depositing resultant source material gas on seed crystal 11.

Specifically, source material 17 is heated by heating units 125 to reach a temperature at which source material 17 is sublimated. A heating method therefor is not particularly limited, but it is preferable to use a high-frequency heating method or a resistive heating method. As a result of the heating, source material 17 is sublimated to generate the sublimation gas (source material gas). This sublimation gas is solidified on the surface of seed crystal 11, which is set at a temperature lower than that of source material 17. Exemplary growth temperatures are as follows. That is, the temperature of source material 17 is maintained at 2300°C-2400°C while the temperature of seed crystal 11 is maintained at 2100°C-2200°C. Accordingly, the SiC crystal is grown on seed crystal 11.

In the step of growing the SiC crystal, heat dissipation portion 131 is filled with atmospheric gas, which has flown into reaction chamber 123 via gas inlet 123a of reaction chamber 123. Under the high temperature condition in which the SiC crystal is grown, heat conduction resulting from radiation from heat dissipation portion 131 becomes predominant. Accordingly, through heat dissipation portion 131, heat can be dissipated from outer surface 101a of crucible 101 at the seed crystal 11 side. Further, because heat dissipation portion 131 is covered with heat insulator 121, SiC crystal can be prevented from being accumulated in heat dissipation portion 131 even when the growth of SiC crystal is continued. This can prevent a change in growth condition during the growth of SiC crystal, such as a change in temperature of seed crystal 11. Hence, a SiC crystal having good crystallinity can be grown, for example, a polytype SiC crystal can be produced as intended.

Next, the inside of production device 100 is cooled down to a room temperature. Then, the SiC crystal produced is taken out from production device 100. In this way, there can be produced SiC crystal 10 (SiC ingot) shown in Fig. 1 and including seed crystal 11 and the SiC crystal formed on seed crystal 11.

It should be noted that SiC crystal 10 shown in Fig. 1 may be produced by removing seed crystal 11 from the SiC ingot. In the case of removing, only seed crystal 11 may be removed or seed crystal 11 and a portion of the SiC crystal grown thereon may be removed.

A method for removing is not particularly limited and may be for example a mechanical removing method such as cutting, grinding, and cleavaging. The term "cutting" herein refers to mechanically removing at least seed crystal 11 from the SiC ingot using a slicer having a peripheral cutting edge of an electrodeposited diamond wheel. The term "grinding" refers to scraping off in a thickness direction using a rotating grinding stone brought into contact with a target surface. The term "cleavaging" refers to dividing a crystal along a crystal plane. In addition, a chemical removing method such as etching may be used.

Further, in the case where SiC crystal 10 produced has a large thickness, SiC crystal 10 shown in Fig. 1 may be produced by cutting a grown SiC crystal to obtain a plurality of SiC crystals. In this case, production cost per SiC crystal 10 can be reduced.

Thereafter, as required, one side or both sides of the crystal may be flattened by grinding, polishing, or the like.

The following describes effects provided by the production method and production device 100 of a SiC crystal in the present embodiment, in comparison to comparative examples shown in Fig. 5 and Fig. 6 as well as the production method and device of a SiC crystal in Non-Patent Literature 1.

First, the production device of a SiC crystal in the comparative example shown in Fig. 5 has basically the same configuration as that of production device 100 of the present embodiment in Fig. 2, but is different therefrom in that it does not include heat dissipation portion 131. In other words, in the production device of the comparative example, the entire portion of crucible 101, including outer surface 101 a at the seed crystal 11 side, is covered with heat insulator 121.

In the comparative example, although the inside of crucible 101 is heated to a high temperature while attempting to allow the temperature at the seed crystal 11 side to be lower than that of source material 17, the temperature of seed crystal 11 is gradually increased. This makes it difficult to appropriately control the sublimation gas of source material 17 to deposit it at the seed crystal 11 side. Accordingly, it becomes difficult to grow the SiC crystal.

Next, the production device of a SiC crystal in Non-Patent Literature 1 in Fig. 6 has basically the same configuration as production device 100 of the present embodiment in Fig. 2, but is different therefrom in that heat dissipation portion 131 is opening 121 a, which is provided to extend through heat insulator 121.

In Non-Patent Literature 1, at an initial stage of the growth of SiC crystal, heat can be dissipated from opening 121 a. Hence, the temperature of seed crystal 11 at the opening 121 a side is low. However, when source material gas leaks from crucible 101 to enter opening 121a during the growth of SiC crystal, crystal is deposited on opening 121 a thus having the low temperature. Accordingly, in the course of the growth of SiC crystal, opening 121a provided in heat insulator 121 is filled therewith. Accordingly, the growth temperature of SiC crystal is changed in the course of the growth. This results in deteriorated crystallinity, such as a change in polytype of the grown SiC crystal from the intended one.

On the other hand, according to the production device and method of a SiC crystal in each of the present embodiment and the first and second variations thereof, heat insulator 121 covers heat dissipation portion 131 provided at outer surface 101 a of crucible 101 at the seed crystal 11 side. Accordingly, even if gas leaks from crucible 101 to enter heat dissipation portion 131, the temperature in heat dissipation portion 131 can be prevented from being decreased, thereby preventing accumulation of SiC crystal in heat dissipation portion 131 (i.e., preventing heat dissipation portion 131 from being filled with a SiC crystal). The present inventor has found, as a result of diligent study, that heat conduction resulting from radiation caused by forming heat dissipation portion 131 becomes predominant under the high temperature condition for the growth of SiC crystal. Hence, in the present embodiment, because heat dissipation portion 131 can be maintained as a space at the growth temperature of SiC crystal during the growth of SiC crystal, heat resulting from radiation and generated at the seed crystal 11 side of crucible 101 can be dissipated by heat conduction to outside production device 100. In other words, via heat dissipation portion 131, a high degree of heat dissipation from crucible 101 can be maintained. Accordingly, during the growth of SiC crystal, the temperature of seed crystal 11 can be prevented from becoming too high, which allows the temperature of seed crystal 11 to be maintained lower than that of source material 17. In other words, in the present embodiment, a difference between the temperature of seed crystal 11 in the initial stage of the growth of SiC crystal and the temperature of seed crystal 11 in the middle stage (or ending stage) of the growth thereof can be smaller than that in Non-Patent Literature 1. This suppresses a change in growth condition such as a change in temperature of seed crystal 11 during the growth of SiC crystal. Hence, a SiC crystal having good crystallinity can be produced.

### [Examples]

Examined in the present examples were effects provided by disposing heat dissipation portion 131, which was constituted by a space, between heat insulator 121 and outer surface 101 a of crucible 101 at the seed crystal 11 side.

### (The Present Invention's Examples 1 and 2)

In the present invention's examples 1 and 2, SiC crystals were produced in accordance with the production method of the embodiment shown in Fig. 2, using production device 100 of the embodiment.

Specifically, first, crucibles 101 each having a hollow cylindrical type and made of graphite were prepared. Each of crucibles 101 had an outer diameter of 140 mm, an inner diameter of 120 mm, and a height of 100 mm.

For each of crucibles 101, three heat insulating sheets were prepared each of which had a thickness of 10 mm and was formed of carbon felt. In the present invention's example 1, openings each having an outer diameter of 20 mm were respectively formed in two of the three heat insulating sheets. In the present invention's example 2, openings each having an outer diameter of 30 mm were respectively formed in two of the three heat insulating sheets. The two heat insulating sheets thus having the openings therein were placed on outer surface 101 a of crucible 101 at the seed crystal 11 side. On the heat insulating sheets thus placed, one remaining heat insulating sheet having no opening formed therein was placed. In doing so, the centers of the openings were adapted to correspond to the center of crucible 101. In this way, a space was formed which was defined by the openings formed in the two heat insulating sheets and the heat insulating sheet having no opening formed therein. This space serves as heat dissipation portion 131. In other words, heat dissipation portion 131 constituted by the space was disposed between heat insulator 121 and outer surface 101a of crucible 101 at the seed crystal 11 side. Further, the heat insulating sheets constituted heat insulator 121.

Then, crucible 101, heat dissipation portion 131, and heat insulator 121 were brought into reaction chamber 123, and high-frequency heating coils serving as heating units 125 were disposed to face the outer circumference of reaction chamber 123.

Further, at the lower portion in crucible 101, source material 17 was placed. SiC powder was used as source material 17. Further, at the upper portion in crucible 101, seed crystal 11 was placed opposite to source material 17. Employed as seed crystal 11 was a 4H-SiC having an outer diameter of 75 mm.

Next, as atmospheric gas, into reaction chamber 123, He gas was supplied at a flow rate of 0.5 slm and N₂ gas was supplied at a flow rate of 0.1 slm. Using the high-frequency heating coils serving as heating units 125, the temperature in crucible 101 was increased. After an indicated value of radiation thermometer 127a, which measured the temperature in crucible 101 at the source material 17 side, reached a defined growth temperature, for example, 2400°C, pressure in crucible 101 was set at 20 Torr. In doing so, power of each high-frequency heating coil was controlled to allow the temperature therein at the seed crystal 11 side to fall below the temperature at the source material 17 side, for example, to be 2200°C. Accordingly, SiC gas was sublimated from source material 17 and a SiC crystal was accordingly grown on seed crystal 11 for a growth time of 50 hours. An intended polytype thereof was 4H-SiC. Thereafter, the temperature in production device 100 was cooled down to a room temperature. In this way, the SiC crystal was produced.

### (Comparative Examples 1-5)

The production device and method of a SiC crystal in each of comparative examples 1-5 were basically the same as those of the present invention's examples 1 and 2, but were different therefrom in that the heat dissipation portion extended through the heat insulator. Specifically, for each of the comparative examples, all the three heat insulating sheets were provided with openings having the same size as indicated in Table 1 below. Then, they were stacked on one another such that these openings overlap with one another, thereby forming opening 121a extending through the heat insulator as shown in Fig. 6. It should be noted that in each of comparative examples 1-5, opening 121b extending to reach the outer circumference of heat insulator 121 was not formed at the source material 17 side of crucible 101.

### (Measurement Method)

For each of comparative examples 1-5, a closure ratio was determined. The closure ratio refers to a ratio of an area of closure of the heat dissipation portion (opening) after the growth of the SiC crystal to an area of the heat dissipation portion (opening) before the growth of the SiC crystal. Results thereof are shown in Table 1 below.

Further, ten SiC crystal substrates were obtained from each grown SiC crystal by means of cutting. These ten SiC crystal substrates were observed by visual inspection to find whether or not a polytype other than 4H-SiC was obtained. When there was a substrate changed in color, the substrate was judged as having a polytype other than 4H-SiC and was regarded as of "unintended polytype". Among the ten SiC crystal substrates, the number of SiC crystal substrates with unintended polytype was measured. Results thereof are shown in Table 1 below.

**[Table 1]**

| | Before Crystal Growth | After Crystal Growth | |
|---|---|---|---|
| | Diameter of Heat Dissipation Portion | Closure Ratio | The Number of Substrates with Unintended Polytype |
| The Present Invention's Example 1 | 20 mm | - | 0 |
| The Present Invention's Example 2 | 30 mm | - | 0 |
| Comparative Example 1 | 20 mm | More Than 90%, Less Than 100% | 2 |
| Comparative Example 2 | 30 mm | 15-40% | 2 |
| Comparative Example 3 | 40 mm | 5-10% | 4 |
| Comparative Example 4 | 50 mm | Less Than 5% | 7 |
| Comparative Example 5 | 60 mm | Less Than 5% | 10 |

### (Results of Measurement)

As shown in Table 1. heat dissipation portion 131 was not filled within the 50 hours of the growth of SiC crystal in the case of production device 100 and the production method in each of the present invention's examples 1 and 2 in which heat dissipation portion 131 constituted by the space was provided between heat insulator 121 and outer surface 101 a of crucible 101 at the seed crystal 11 side. This suppressed a change in growth condition during the growth of SiC crystal. Hence, the SiC crystal substrates obtained from the grown SiC crystal by means of cutting had no unintended polytype.

In contrast, at least a portion of opening 121 a serving as the heat dissipation portion was filled with crystal within the 50 hours of the growth of SiC crystal in the case of the production device of each of comparative examples 1-5 in which heat insulator 121 is provided with opening 121 a located at outer surface 101 a of crucible 101 at the seed crystal 11 side, having a diameter of 20 mm-60 mm, and extending therethrough. This resulted in a change in growth condition in the middle of the growth. Accordingly, there were SiC crystal substrates with unintended polytype, among those obtained from the SiC crystal by mean of cutting.

Further, heat dissipation from outer surface 101a of crucible 101 at the seed crystal 11 side was too large in the initial stage of the growth in each of the production devices of comparative examples 3-5 in each of which heat insulator 121 was provided with opening 121 a having a diameter of 40 mm-60 mm at outer surface 101 a of crucible 101 at the seed crystal 11 side. This resulted in excessive decrease in the temperature of seed crystal 11, thereby further increasing the number of SiC crystal substrates with unintended polytype.

As such, according to the present examples, it was confirmed that a SiC crystal having good crystallinity can be produced by providing heat dissipation portion 131, which is constituted by a space, between heat insulator 121 and outer surface 101 a of crucible 101 at the seed crystal 11 side.

Heretofore, the embodiments and examples of the present invention have been illustrated, but it has been initially expected to appropriately combine features of the embodiments and examples. The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

### REFERENCE SIGNS LIST

10: SiC crystal; 11: seed crystal; 17: source material; 100: production device; 101: crucible; 101 a, 101b: outer surface; 121: heat insulator; 121 a, 121 b: opening; 121 c: temperature measurement hole; 123: reaction chamber; 123a: gas inlet; 123b: gas outlet; 125: heating unit; 127a, 127b: radiation thermometer; 131, 132: heat dissipation portion.

## Claims

1. A production method of a silicon carbide crystal (10), comprising the steps of:
preparing a production device (100) including a crucible (101) and a heat insulator (121) covering an outer circumference of said crucible (101);
placing a source material (17) in said crucible (101);
placing a seed crystal (11) opposite to said source material (17) in said crucible (101); and
growing the silicon carbide crystal (10) by heating said source material (17) in said crucible (101) for sublimation thereof and depositing resultant source material gas on said seed crystal (11),
the step of preparing said production device (100) including the step of providing a heat dissipation portion (131, 132), which is constituted by a space, between said heat insulator (121) and an outer surface (101a) of said crucible (101) at a side of said seed crystal (11).

2. The production method of the silicon carbide crystal (10) according to claim 1, wherein in the step of preparing said production device (100), said heat insulator (121) prepared contains carbon as its main component.

3. The production method of the silicon carbide crystal (10) according to claim 1, wherein in said production device (100) prepared in the step of preparing said production device (100), said heat insulator (121) covering the outer circumference of said crucible (101) is formed of a plurality of heat insulating sheets stacked on one another.

4. The production method of the silicon carbide crystal (10) according to claim 1, wherein in the step of growing said silicon carbide crystal (10), said source material (17) is heated using a high-frequency heating method or a resistive heating method.

5. The production method of the silicon carbide crystal (10) according to claim 1, wherein in the step of preparing said production device (100), said crucible (101) prepared contains carbon as its main component.

6. A silicon carbide crystal (10) produced by the production method of the silicon carbide crystal (10) as recited in claim 1.

7. The silicon carbide crystal (10) according to claim 6, wherein the silicon carbide crystal (10) has a crystalline polymorphism of 4H-SiC.

8. A production device (100) of a silicon carbide crystal (10) for growing the silicon carbide crystal (10) by sublimating a source material (17) containing silicon carbide, and depositing source material gas, which results from the sublimation, on a seed crystal (11), the production device (100) comprising:
a crucible (101) for containing said source material (17) and said seed crystal (11) therein;
a heat insulator (121) covering an outer circumference of said crucible (101);
a heat dissipation portion (131, 132) constituted by a space and provided between said heat insulator (121) and an outer surface (101a) of said crucible (101) at a side of said seed crystal (11); and
a heating unit (125) for heating inside of said crucible (101).

9. The production device (100) for the silicon carbide crystal (10) according to claim 8, wherein said heat insulator (121) contains carbon as its main component.

10. The production device (100) for the silicon carbide crystal (10) according to claim 8, wherein said heat insulator (121) is formed of a plurality of heat insulating sheets stacked on one another.

11. The production device (100) for the silicon carbide crystal (10) according to claim 8, wherein said heating unit (125) is a high-frequency heating coil or a resistive heating heater.

12. The production device (100) for the silicon carbide crystal (10) according to claim 8, wherein said crucible (101) contains carbon as its main component.
